**Europäisches Patentamt**

**European Patent Office**

**Office européen des brevets**

(11) Numéro de publication : **0 136 941**
**B1**

(12)

# FASCICULE DE BREVET EUROPÉEN

(45) Date de publication du fascicule du brevet :
**09.11.88**

(51) Int. Cl.⁴ : **H 01 P 1/15, H 01 L 29/90**

(21) Numéro de dépôt : **84401913.3**

(22) Date de dépôt : **26.09.84**

(54) Perfectionnement aux commutateurs d'ondes électromagnétiques millimétriques.

(30) Priorité : **30.09.83 FR 8315650**

(43) Date de publication de la demande :
**10.04.85 Bulletin 85/15**

(45) Mention de la délivrance du brevet :
**09.11.88 Bulletin 88/45**

(84) Etats contractants désignés :
**DE GB NL**

(56) Documents cités :
**EP-A- 0 073 165**
**RCA REVIEW, vol. 38, no. 3, septembre 1977, pages 390-405, Princeton, US ; Y.S. CHIANG et al.: "Low-resistance all-epitaxial PIN diodes for ultra-high-frequency applications"**

(73) Titulaire : **THOMSON-CSF**
**173, Boulevard Haussmann**
**F-75379 Paris Cédex 08 (FR)**

(72) Inventeur : **Henry, Raymond**
**THOMSON-CSF SCPI 173, bld Haussmann**
**F-75379 Paris Cedex 08 (FR)**
Inventeur : **Heitzmann, Michel**
**THOMSON-CSF SCPI 173, bld Haussmann**
**F-75379 Paris Cedex 08 (FR)**
Inventeur : **Sillard, Gilles**
**THOMSON-CSF SCPI 173, bld Haussmann**
**F-75379 Paris Cedex 08 (FR)**

**0 136 941**

## Description

La présente invention concerne un commutateur d'ondes électromagnétiques réalisé à partir d'une diode PIN montée dans un guide d'ondes et fonctionnant pour des ondes millimétriques, notamment à 94 GHz. Le but d'un tel dispositif est de transmettre avec une perte minimale de puissance des signaux hyperfréquence et d'atténuer au maximum ces mêmes signaux grâce à deux états de polarisation.

On connaît déjà une structure de commutateur d'ondes électromagnétiques millimétriques à diode PIN, comme cela est décrit dans la demande de brevet européen déposée par la Demanderesse et publiée sous le n° EP-A-0 073 165, concernant : « Commutateur d'ondes électromagnétiques ». Selon cette demande de brevet, le commutateur est constitué par un guide d'ondes rectangulaire ridge métallique, par exemple en cuivre, et dont les dimensions permettent la propagation d'ondes millimétriques, avec une diode PIN en silicium de type classique associée à un circuit de polarisation et montée dans l'espace ridge, de volume déterminé, ménagé par le guide.

Toujours selon cette demande de brevet, la diode PIN a un volume identique à celui de l'espace ridgé et dans un exemple particulier de réalisation mentionné dans la demande, les dimensions de la section droite du guide sont égales à 2,54 mm sur 1,27 mm, tandis que celles de la diode PIN classique sont égales à 0,6 mm de largeur sur 0,4 mm d'épaisseur et à 0,7 mm selon l'axe longitudinal du guide. Cette dernière dimension de la diode PIN correspond à $3\lambda_g/4$, c'est-à-dire à un multiple du quart de la longueur d'onde guidée $\lambda_g$ à la fréquence de fonctionnement de 94 GHz.

En outre, il est connu qu'une diode PIN classique possède des zones ou régions $P^+$ et $N^-$ épaisses, de l'ordre de 30 à 80 microns, ceci dans le but d'obtenir des tensions de claquage très élevées.

Sur la base des dimensions données ci-dessus de la diode PIN classique, avec des couches respectives $P^+$ et $N^-$ de 40 microns d'épaisseur, la Demanderesse a effectué des essais de ce type de commutateur d'ondes électromagnétiques millimétriques selon l'art antérieur, à une fréquence de fonctionnement de 94 GHz et pour une forte puissance incidente pulsée de 1 kW.

Or, les performances relevées pour ce commutateur sont médiocres, et en particulier les pertes d'insertion mesurées à bas niveau et à polarisation nulle sont trop importantes, de l'ordre de 4 dB montage compris dont 3,4 dB dus à la diode PIN. Quant à l'isolation mesurée en polarisation directe avec une valeur de courant de l'ordre de 20 mA, celle-ci est d'environ 20 dB, ce qui est relativement médiocre. Par conséquent, cette diode PIN classique de commutation n'est pas suffisamment performante en ondes millimétriques.

La présente invention a pour but de concevoir une diode PIN pour la commutation à forte puissance incidente d'ondes électromagnétiques millimétriques, notamment à 94 GHz, et montée dans un guide d'ondes ridgé, qui permet par un choix approprié de ses dimensions d'améliorer voire d'optimiser les performances globales du commutateur selon l'art antérieur, et en particulier les pertes d'insertion, tout en ayant une excellente tenue en puissance.

A cet effet, l'invention a pour objet un commutateur d'ondes électromagnétiques constitué par un guide d'ondes rectangulaire métallique, d'axe longitudinal ($\Delta$), muni d'un redan métallique ménageant un espace ridgé dans lequel est disposé une diode PIN, ledit guide étant construit en deux parties dont l'une est une plaque métallique plane et dont l'autre est une plaque métallique en forme de U comportant le redan, la réunion des deux parties réalisant la cavité dudit guide d'ondes, et ces deux parties étant isolées l'une de l'autre par une couche de matériau isolant, ce commutateur étant caractérisé en ce que les zones $P^-$ et $N^+$ de ladite diode ont chacune une épaisseur inférieure à l'épaisseur de peau respective pour ces zones $P^+$ et $N^-$ à la fréquence de fonctionnement désirée, l'épaisseur de chaque zone $P^+$ et $N^-$ étant comprise entre 2 et 5 microns, pour une fréquence de fonctionnement de l'ordre de 94 GHz et pour une résistivité de chaque zone $P^+$ et $N^+$ de la diode de l'ordre de $0,007\Omega.cm$, ledit guide d'ondes étant en cuivre, donnant ainsi une épaisseur de peau respective pour lesdites zones $P^+$ et $N^-$ de l'ordre de 15 microns.

Selon une autre caractéristique de l'invention, la dimension de la diode PIN selon l'axe longitudinal du guide est un multiple de la demi-longueur d'onde guidée à la fréquence centrale de la bande de fonctionnement.

Selon encore un aspect de l'invention, la largeur de la diode PIN est comprise entre 0,15 mm et 0,40 mm à la fréquence de fonctionnement considérée.

Ainsi, la combinaison de ces trois caractéristiques de l'invention conduit à l'obtention d'une diode PIN optimale pour la commutation d'ondes électromagnétiques du domaine millimétrique.

D'autres caractéristiques et avantages de l'invention apparaîtront mieux dans la description détaillée qui suit et se réfère aux dessins annexés, donnés uniquement à titre d'exemple et dans lesquels :
— la figure 1 représente une vue en coupe du commutateur selon l'invention suivant une section droite du guide ;
— la figure 2 représente une vue en perspective de la diode PIN utilisée pour la commutation ; et
— la figure 3 représente une vue en perspective du commutateur de la figure 1.
Sur ces différentes figures, les mêmes références se rapportent aux mêmes éléments.

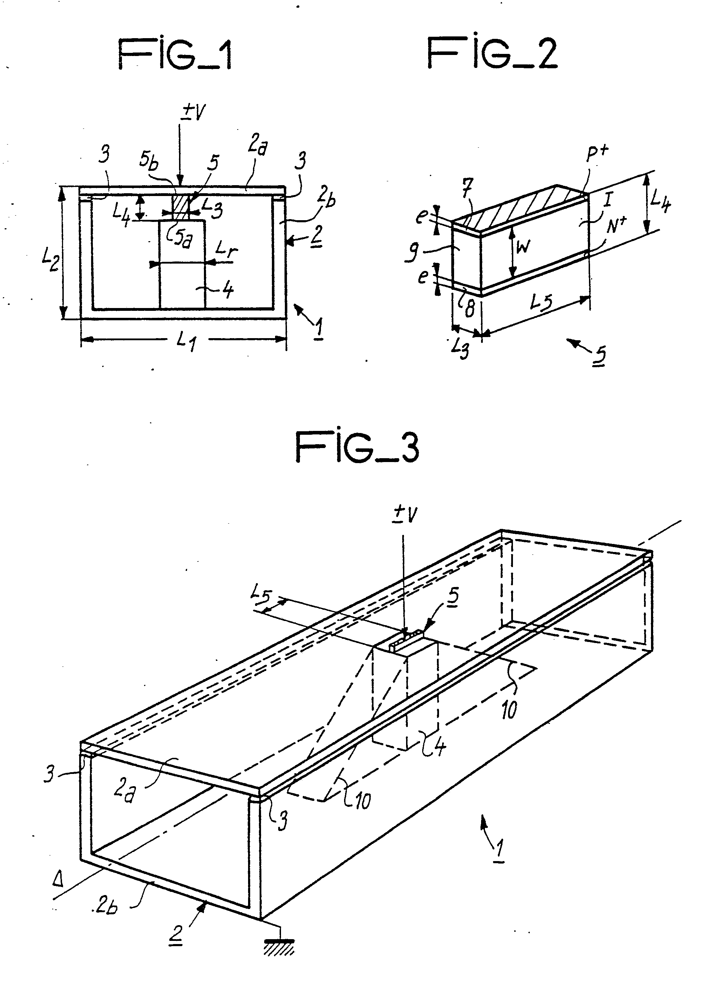

La figure 1 représente un commutateur 1 d'ondes électromagnétiques selon l'invention, vu en coupe selon une section droite, et destiné à fonctionner dans la bande de fréquence de l'ordre de 93 GHz à

2

95 GHz. Il est réalisé à partir d'un guide d'ondes 2 rectangulaire, construit en deux parties dont l'une est une plaque métallique plane 2a, par exemple en cuivre, et dont l'autre est une plaque métallique 2b en forme de U, par exemple également en cuivre, la réunion des deux plaques réalisant la cavité du guide d'ondes. Les deux plaques sont isolées l'une par rapport à l'autre par une couche de matériau isolant 3.

De façon à réaliser un guide d'ondes dit moulure ou ridgé ou encore dénommé « ridged » selon le vocable anglo-saxon, la plaque 2b comporte dans sa partie centrale un redan métallique 4, par exemple en cuivre, ménageant dans le guide 2 un espace dit ridgé dans lequel est concentré le champ électrique. Dans cet espace ridgé est disposé un barreau semiconducteur 5 de forme parallélépipédique de section droite rectangulaire.

Etant donné les dimensions du guide d'ondes fonctionnant en ondes millimétriques, par exemple à une fréquence d'utilisation de 94 GHz, on peut mettre une puce de semiconducteur telle qu'une diode PIN en silicium dans l'espace ridgé. Dans un exemple particulier de réalisation, les dimensions de la section droite du guide 2 sont :

$$L_1 = 2,54 \text{ mm et } L_2 = 1,27 \text{ mm}$$

et celles de l'espace ridgé sont :

$$L_r = 0,6 \text{ mm et } L_4 = 0,4 \text{ mm}$$

La cathode 5a de la diode PIN 5 est reliée au redan 4 tandis que son anode 5b est reliée à la plaque 2a. La diode est polarisée par application d'une tension ± V entre ces deux parties. De plus, pour assurer une bonne dissipation thermique, les deux faces opposées métallisées de la diode 5 sont respectivement soudées l'une à la plaque 2a et l'autre au redan 4.

Le fonctionnement de ce type de commutateur est le suivant.

Lorsque la diode PIN est bloquée, le guide d'une part peut être considéré comme rempli d'un matériau diélectrique de constante diélectrique ε élevée et d'autre part a des dimensions telles que la propagation d'une onde millimétrique est possible. Dans ce cas, une telle onde est transmise à travers le commutateur.

Par contre, lorsque la diode PIN conduit, elle est équivalente à une résistance et l'onde millimétrique incidente est absorbée par la diode d'autant mieux que l'on est proche de l'adaptation d'impédance.

On va maintenant décrire la structure de la diode PIN en silicium 5 pour la commutation en ondes millimétriques, conformément à un mode de réalisation préféré de l'invention, en se reportant à la figure 2 sur laquelle les dimensions de la diode ont été exagérées dans un souci de clarté.

On rappellera tout d'abord que la diode PIN de commutation d'ondes électromagnétiques, en polarisation nulle ou inverse et montée dans l'espace ridgé du guide d'ondes, peut être assimilée à une capacité connectée en série avec une résistance introductive de pertes à la fréquence de fonctionnement considérée.

Selon un aspect de l'invention, la diode PIN 5, par exemple découpée brute de sciage, présente deux zones ou régions 7 et 8 dopées respectivement $P^+$ et $N^+$ qui ont chacune une épaisseur e choisie de telle sorte qu'elle soit inférieure à l'épaisseur de peau δ respective pour ces zones $P^+$ et $N^+$ à la fréquence de fonctionnement considérée.

Des diodes ayant une très fine épaisseur de couches $P^+$ et $N^+$ sont en soi connues. Cette épaisseur peut être inférieure à l'épaisseur de peau. Par exemple dans l'article « Low Resistance All-Expitaxial PIN Diodes ... » paru dans RCA Review, vol 38, n° 3, pages 390-405, de septembre 1977, est décrite une diode dont l'épaisseur de la couche $P^+$ est 5 μm, et l'épaisseur de la couche $N^+$ est 1 μm, soient inférieures aux épaisseurs de peau entre 500 MHz et 8 GHz. Mais ces faibles épaisseurs ont pour objet d'abaisser la résistance de la diode en polarisation directe.

Comme cela est connu, à haute fréquence, le matériau semiconducteur de la diode PIN montée entre deux plans conducteurs, par exemple en cuivre, est soumis à l'effet de peau de sorte que le courant dans la diode se localise dans une épaisseur de peau δ pour chacune des zones $P^+$ et $N^+$ définie par :

$$\delta(P^+ \; ; N^+) = \delta(\text{cuivre}) \cdot \sqrt{\frac{\rho(P^+ \; ; N^+)}{\rho(\text{cuivre})}}$$

où $\rho(P^+ ; N^+)$ est la résistivité de la zone $P^+$ ou $N^+$, $\rho$ (cuivre) est la résistivité du cuivre égale à $1,7.10^{-6}$ Ω.cm, et δ (cuivre) exprimée en cm est l'épaisseur de peau pour le cuivre égale à $6,6/\sqrt{f}$ où f est la fréquence de fonctionnement exprimée en Hz.

soit :

$$\delta(P^+ \; ; N^+) = \frac{6,6}{\sqrt{f}} \sqrt{\frac{\rho(P^+ \; ; N^+)}{1,7.10^{-6}}}$$

exprimée en cm pour f en Hz et $\rho(P^+ ; N^+)$ en Ω.cm.

**0 136 941**

Ainsi pour une fréquence de fonctionnement de 94 GHz, et pour une diode PIN en silicium dont la couche dopée $P^+$ est de résistivité de l'ordre de 0,01 $\Omega$.cm et la couche dopée $N^+$ est de résistivité de l'ordre de 0,0065 $\Omega$.cm, et ceci à dopage égal ($10^{19}$ atomes/cm$^3$), les couches $P^+$ et $N^+$ ont des épaisseurs de peau respectives de l'ordre

$$\delta = 17 \text{ microns pour la couche } P^+$$
$$\delta = 13 \text{ microns pour la couche } N^+$$

Donc, le fait de choisir des épaisseurs des couches $P^+$ et $N^+$ inférieures à leurs épaisseurs de peau respectives permet au courant dans la diode de passer plus rapidement dans le matériau conducteur du guide, par exemple en cuivre, ce qui a pour effet de diminuer les pertes d'insertion de la diode à la fréquence de fonctionnement considérée. Et de plus, en choisissant des valeurs d'épaisseur des couches $P^+$ et $N^+$ très inférieures à celles de leurs épaisseurs de peau respectives, le courant dans la diode passe pour une part importante dans le cuivre, donc pratiquement sans se localiser dans les zones en silicium dopé, permettant ainsi de diminuer encore plus les pertes d'insertion de la diode.

Par expérience, une valeur d'épaisseur e des couches $P^+$ et $N^+$ comprise entre 2 et 5 microns apparaît comme un bon compromis pour l'obtention de très faibles pertes, en particulier à la fréquence de fonctionnement de 94 GHz et pour une résistivité de chaque zone $P^+$ et $N^+$ de l'ordre de 0,007 $\Omega$.cm, le guide d'ondes ridgé étant en cuivre, donnant ainsi une épaisseur de peau respective pour les zones $P^+$ et $N^+$ de l'ordre de 15 microns.

Par conséquent, la diode PIN utilisée dans le cadre de l'invention possède des zones $P^+$ et $N^+$ très minces, de l'ordre de 2 à 5 microns d'épaisseur, et n'est donc pas une diode PIN classique pour laquelle les couches $P^+$ et $N^+$ sont épaisses, de l'ordre de 40 microns, à la fréquence d'utilisation considérée à 94 GHz. .

Concernant l'épaisseur $L_4$ de la diode PIN 5, celle-ci est fixée par la hauteur de l'espace ridgé, soit dans l'exemple choisi, $L_4 = 0,4$ mm. Cette valeur d'épaisseur de la diode résulte à la fois des contraintes imposées par la tenue en puissance et de la recherche d'un temps de commutation pas trop élevé. De plus, l'obtention d'une impédance de redan de l'ordre de 100 ohms permet de polariser en direct la diode pour qu'elle absorbe la puissance incidente avec des valeurs classiques de courant (quelques mA à quelques dizaines de mA), tout en présentant un échauffement faible.

Comme il apparaît sur la figure 2, la diode PIN 5 possède une zone 9 de matériau intrinsèque I disposée entre les deux zones dopées $P^+$ et $N^+$, et d'épaisseur W de l'ordre de 390 microns dans l'exemple choisi, c'est-à-dire avec $L_4 = 400$ microns et une épaisseur e de chaque couche $P^+$ et $N^+$ de l'ordre de 5 microns.

Toujours dans le but d'améliorer les performances globales de la diode PIN de commutation 5, la largeur $L_3$ de celle-ci est choisie de telle sorte qu'elle soit comprise entre 0,15 mm et 0,40 mm à la fréquence de fonctionnement considérée. Ces deux valeurs correspondent respectivement à un quart et à deux tiers de la largeur $L_r$ du redan égale à 0,6 mm dans l'exemple déjà indiqué. Par conséquent, la largeur de la diode PIN est désormais inférieure à celle du redan, et donc le volume de la diode n'est plus identique à celui défini par l'espace ridgé.

Ces valeurs de 0,15 mm et de 0,40 mm pour la largeur $L_3$ de la diode PIN constitue des valeurs critiques en ce sens qu'il a été montré, par expérience, que pour des valeurs supérieures à 0,40 mm les pertes d'insertion relevées étaient trop importantes, et que pour des valeurs inférieures à 0,15 mm d'une part la diode n'absorbait pas toute la puissance incidente de sorte que son isolation relevée était trop faible et d'autre part la résistance thermique de la diode augmentait conduisant à un échauffement prohibitif de cette dernière.

Pour une fréquence de fonctionnement de 94 GHz, une valeur de l'ordre de 0,2 mm pour la largeur $L_3$ de la diode PIN apparaît comme une valeur optimale pour l'obtention de très bonnes performances de la diode.

Sur la figure 3, les transitions entre l'espace ridgé et le guide d'ondes sont assurées par des biseaux 10 ou « tapers » selon le vocable anglo-saxon, qui sont équivalents à des transformateurs adaptant les impédances. Pour compenser les réflexions sur les faces de la diode, la dimension de celle-ci repérée par $L_5$, selon l'axe longitudinal $\Delta$ du guide d'ondes, est un multiple de la demi-longueur d'onde guidée ($\lambda_g/2$) à la fréquence centrale de la bande de fonctionnement. De façon préférentielle, cette dimension $L_5$ de la diode est égale à $\lambda_g$ car il a été montré, par expérience, que pour des valeurs de $L_5$ égales à $\lambda_g/2$ l'isolation de la diode était moins bonne et que pour des valeurs $L_5$ égales ou supérieures à $3\lambda_g/2$ les pertes d'insertion étaient plus élevées.

Ainsi, pour une fréquence de fonctionnement de 94 GHz, la longueur d'onde guidée dans le silicium $\lambda_g$ est de l'ordre de 1,1 mm, et une valeur de l'ordre de 1,1 mm pour la dimension $L_5$ de la diode apparaît donc comme une valeur optimale pour l'obtention de très bonnes performances globales.

Les diverses valeurs de dimensions de la diode PIN données ci-dessus permettent donc d'optimiser la diode à la fréquence d'utilisation considérée, et en particulier à 94 GHz. En effet, à cette fréquence de 94 GHz, la capacité de la diode à polarisation nulle est donnée par :

4

0 136 941

$$C = \frac{\varepsilon S}{W}$$

où $$\varepsilon = \frac{12}{36\,\pi.10^9} \text{ en MKSA}$$

W = épaisseur de la zone I, soit de l'ordre de 0,39 mm

S = section de la zone I = $L_3 \times L_5$, soit 0,2 mm $\times$ 1,1 mm ce qui donne une faible valeur de capacité C de l'ordre de $5,8.10^{-2}$ pF, soit une impédance $1/C\omega$ de l'ordre de 30 ohms. Cette valeur élevée d'impédance de la diode a pour avantage de faciliter l'adaptation d'impédance par des pièces de couplage appelées iris (non représentés) disposés à l'entrée et à la sortie du guide d'ondes.

D'autre part, comme le guide d'ondes électromagnétiques est destiné à transmettre uniquement le mode 1, le fait d'avoir une largeur $L_3$ de diode de l'ordre de 0,2 mm petite devant la longueur d'onde dans le silicium, de l'ordre de 1,1 mm pour une fréquence de 94 GHz, permet d'éviter toute perturbation par les modes supérieurs.

Les résultats obtenus par la structure de la diode PIN décrite ci-dessus sont particulièrement significatifs, à la fréquence de 94 GHz : ainsi, pour une puissance incidente pulsée de 1 kW, les pertes d'insertion mesurées à bas niveau et à polarisation nulle sont très faibles, de l'ordre de 1 dB montage compris dont 0,4 dB seulement dû à la diode. Quant à l'isolation mesurée en polarisation directe avec une valeur de courant de 20 mA, celle-ci est élevée, de l'ordre de 30 à 35 dB.

De plus, pour une résistivité apparente en polarisation directe de la zone I de la diode en silicium de l'ordre de 3 $\Omega$.cm, l'épaisseur de peau pour cette zone est de l'ordre de 300 microns, de sorte qu'en admettant que l'énergie correspondant à 1 kW pendant une microseconde est dissipée en totalité dans une tranche de silicium de dimensions 200 microns ($L_3$) $\times$ 400 microns ($L_4$) $\times$ 300 microns, l'échauffement obtenu de la diode est très faible, de l'ordre de 13 °C : une telle diode PIN peut donc supporter des puissances et des durées d'impulsion nettement plus élevées.

Par conséquent, cette diode PIN est particulièrement performante en ondes millimétriques et peut être considérée comme optimale en raison de la combinaison de ses dimensions particulières qui sont, pour une fréquence de fonctionnement de 94 GHz donnant les résultats indiqués ci-dessus :

— épaisseur e de chaque couche $P^+$ et $N^+$ : 5 microns
— épaisseur $L_4$ : 0,4 mm
— largeur $L_3$ : 0,2 mm
— dimension $L_5$ selon l'axe longitudinal du guide : 1,1 mm

On notera que la structure de la diode PIN a été décrite ci-dessus pour une diode en silicium. Bien sûr, l'invention peut également s'appliquer à une diode PIN en arséniure de gallium avec du matériau intrinsèque I dopé à quelques $10^{13}$ atomes/cm³.

**Revendications**

1. Commutateur d'ondes électromagnétiques constitué par un guide d'ondes (2) rectangulaire métallique, d'axe longitudinal ($\Delta$), muni d'un redan (4) métallique ménageant un espace ridgé dans lequel est disposée une diode PIN (5), ledit guide étant construit en deux parties dont l'une est une plaque métallique plane (2a) et dont l'autre est une plaque métallique (2b) en forme de U comportant le redan, la réunion des deux parties réalisant la cavité dudit guide d'ondes, et ces deux parties étant isolées l'une de l'autre par une couche de matériau isolant (3), ce commutateur étant caractérisé en ce que les zones $P^+$ et $N^+$ de ladite diode ont chacune une épaisseur (e) inférieure à l'épaisseur de peau respective pour ces zones $P^+$ et $N^+$ à la fréquence de fonctionnement désirée, l'épaisseur de chaque zone $P^+$ et $N^+$ étant comprise entre 2 et 5 microns, pour une fréquence de fonctionnement de l'ordre de 94 GHz et pour une résistivité de chaque zone $P^+$ et $N^+$ de la diode de l'ordre de 0,007 $\Omega$.cm, ledit guide d'ondes (2) étant en cuivre, donnant ainsi une épaisseur de peau respective pour lesdites zones $P^+$ et $N^+$ de l'ordre de 15 microns.

2. Commutateur selon la revendication 1, caractérisé en ce que la diode PIN (5) se présente sous forme d'un barreau parallélépipédique de section droite rectangulaire dont la dimension ($L_5$) selon l'axe longitudinal ($\Delta$) du guide est un multiple de la demi-longueur d'onde guidée ($\lambda g/2$) à la fréquence centrale de la bande de fonctionnement.

3. Commutateur selon la revendication 2, caractérisé en ce que, pour une fréquence de fonctionnement de l'ordre de 94 GHz, la demi-longueur d'onde guidée ($\lambda g/2$) étant de l'ordre de 0,55 mm, la dimension ($L_5$) de la diode PIN selon l'axe longitudinal ($\Delta$) est égale au double de la demi-longueur d'onde guidée, soit de l'ordre de 1,1 mm.

4. Commutateur selon l'une des revendications 2 ou 3, caractérisé en ce que la largeur ($L_3$) de la diode PIN est comprise entre 0,15 mm et 0,40 mm à la fréquence de fonctionnement considérée.

5. Commutateur selon la revendication 4, caractérisé en ce que la largeur ($L_3$) de la diode PIN est de l'ordre de 0,2 mm à la fréquence de fonctionnement de l'ordre de 94 GHz.

5

6. Commutateur selon l'une des revendications précédentes, caractérisé en ce que l'épaisseur ($L_4$) de la diode PIN est de l'ordre de 0,40 mm à la fréquence de fonctionnement de l'ordre de 94 GHz.

7. Commutateur selon l'une des revendications précédentes, caractérisé en ce que la diode PIN (5) est en silicium.

8. Commutateur selon la revendication 1, caractérisé en ce que la diode PIN (5) a ses deux faces opposées métallisées respectivement soudées l'une à la plaque plane (2a) et l'autre au redan (4) du guide (2).

## Claims

1. An switch for electromagnetic waves, constituted of a rectangular metallic wave guide (2) having a longitudinal axis (Δ) and being equipped with a metallic step (4) providing a ridged space within which is disposed a PIN diode (5), the guide being composed of two portions, one of which is a flat metallic plate (2a) and the other is a metallic plate (2b) having an U-profile and comprising the step, the unification of the two portions creating the cavity of the wave guide, and these two portions being insulated from each other by a layer (3) of insulating material, characterized in that each of the zones $P^+$ and $N^+$ of the diode has a smaller thickness (e) than the respective skin thickness of the zones $P^+$ and $N^-$ at the desired operating frequency, the thickness of each zone $P^+$ and $N^+$ being comprised between 2 and 4 micrometer at an operating frequency of the order of 94 GHz and a resisitivity of each zone $P^+$ and $N^-$ of the diode in the order of 0,007 cm, the wave guide being made of copper, whereby the respective skin thickness amounts to the order of 15 micrometer for the zones $P^+$ and $N^+$.

2. A switch according to claim 1, characterized in that the PIN-diode (5) assumes the shape of a parallelepipedic bar of rectangular section, the dimension ($L_5$) of which along the longitudinal axis (Δ) of the guide is a multiple of the guided wave's half-length ($\lambda g/2$) at the central operating frequency.

3. A switch according to claim 2, characterized in that for an operating frequency of about 94 GHz, for which the guide wave's half length ($\lambda g/2$) is about 0,55 mm, the dimension ($L_5$) of the PIN diode along the longitudinal axis (Δ) is twice the guided wave's half-length, that is about 1,1 mm.

4. A switch according to one of the claims 2 or 3, characterized in that the width ($L_3$) of the PIN diode is comprised between 0,15 mm and 0,40 mm at the considered operating frequency.

5. A switch according to claim 4, characterized in that the width ($L_3$) of the PIN diode is about 0,2 mm at an operating frequency of about 94 GHz.

6. A switch according to one of the preceding claims, characterized in that the thickness ($L_4$) of the PIN diode is about 0,40 mm at an operating frequency of about 94 GHz.

7. A switch according to one of the preceding claims, characterized in that the PIN diode (5) is made of silicon.

8. A switch according to claim 1, characterized in that one of the two opposed and metallized faces of the PIN diode (5) is welded to the flat plate (2a) and the other to the step (4) of the guide (2).

## Patentansprüche

1. Schalter für elektromagnetische Wellen, bestehend aus einem rechteckigen metallischen Wellenleiter mit einer Längsachse (Δ) und einer metallischen Stufe (4), die einen Firstspalt freiläßt, in welchem eine PIN-Diode (5) angeordnet ist, wobei der Wellenleiter aus zwei Teilen besteht, von denen einer eine ebene metallische Platte (2a) und der andere eine U-förmige metallische Platte (2b) mit der Stufe ist und die Vereinigung der beiden Teile den Hohlraum des Wellenleiters erzeugt, und wobei die beiden Teile voneinander durch eine Schicht (3) aus isolierendem Material isoliert sind, dadurch gekennzeichnet, daß die Zonen $P^+$ und $N^+$ der Diode jeweils eine Dicke (e) besitzen, die kleiner als die entsprechende Skindicke für diese Zonen $P^+$ und $N^+$ bei der gewünschten Betriebsfrequenz ist, wobei die Dicke jeder Zone $P^+$ und $N^+$ zwischen 2 und 5 Mikrometer für eine Betriebsfrequenz von größenordnungsnmäßig 94 GHz und für einen spezifischen Widerstand jeder der Diodenzonen $P^+$ und $N^-$ von größenordnungsmäßig 0,007 Ω cm liegt, wobei der Wellenleiter (2) aus Kupfer besteht, so daß er für die genannten Zonen $P^+$ und $N^+$ eine entsprechende Skindicke von größenordnungsmäßig 15 Mikrometer ergibt.

2. Schalter nach Anspruch 1, dadurch gekennzeichnet, daß die PIN-Diode (5) in Gestalt eines parallelepipedischen Balkens mit rechtwinkligem Querschnitt vorliegt, dessen Abmessung ($L_5$) in Richtung der Längsachse (Δ) des Wellenleiters ein Vielfaches der halben Wellenlänge ($\lambda g/2$) für die mittlere Frequenz des Betriebsfrequenzbands beträgt.

3. Schalter nach Anspruch 2, dadurch gekennzeichnet, daß bei einer Betriebsfrequenz in der Größenordnung von 94 GHz, bei der die halbe Wellenlänge ($\lambda g/2$) etwa 0,55 mm beträgt, die Abmessung ($L_5$) der PIN-Diode in Richtung der Längsachse (Δ) gleich dem Doppelten der halben Wellenlänge ist, also etwa 1,1 mm.

4. Schalter nach einem der Ansprüche 2 oder 3, dadurch gekennzeichnet, daß die Breite ($L_3$) der PIN-Diode bei der betrachteten Betriebsfrequenz zwischen 0.15 mm und 0,40 mm liegt.

5. Schalter nach Anspruch 4, dadurch gekennzeichnet, daß die Breite der PIN-Diode etwa 0,2 mm bei der Betriebsfrequenz von etwa 94 GHz beträgt.

6. Schalter nach einem der vorhergehenden Ansprüche, dadurch gekennzeichnet, daß die Dicke ($L_4$) der PIN-Diode etwa 0,40 mm bei der Betriebsfrequenz von etwa 94 GHz beträgt.

7. Schalter nach einem der vorhergehenden Ansprüche, dadurch gekennzeichnet, daß die PIN-Diode (5) aus Silicium besteht.

8. Schalter nach Anspruch 1, dadurch gekennzeichnet, daß die eine der einander gegenüberliegenden metallisierten Seiten der PIN-Diode (5) mit der ebenen Platte (2a) und die andere Seite mit der Stufe (4) des Wellenleiters (2) verschweißt ist.

# FIG_1

# FIG_2

# FIG_3